# EUROPÄISCHE PATENTANMELDUNG

(11) **EP 0 865 155 A1**
(43) Veröffentlichungstag der Anmeldung: **16.09.1998**
(21) Anmeldenummer: 97104089.4
(22) Anmeldetag: 11.03.1997
(51) Int. Cl.: H03G 3/30

(54) **Schaltungsanordnung zur Unterdrückung des Rauschens im Empfangsteil eines CB-Funkgerätes oder eines CB-Empfängers**

(71) Anmelder: Albrecht Electronic GmbH, 22946 Trittau (DE)
(72) Erfinder: Meyer, Dirk, Dipl.-Ing., 25980 Westerland, Sylt (DE)
(74) Vertreter: Maiwald, Walter, Dr. Dipl.-Chem.

(57) **Zusammenfassung**

Die Erfindung betrifft eine Schaltungsanordnung zur Unterdrückung des Rauschens im Empfangsteil eines CB-Funkgerätes oder eines CB-Empfängers, bei der im NF-Pfad in einem Regelverstärker und einer nachgeschalteten Einheit zur Regelspannungserzeugung eine der Lautstärkeregelstufe zugeführte Regelspannung abgeleitet wird. Der Rauschverstärker ist erfindungsgemäß aus einer hinsichtlich ihres Ansprechens einstellbaren Verstärkerstufe und einem schmalbandigen Hochpaßfilter gebildet, wobei der Frequenzgang des Filters an das typische Störspektrum des CB-Funks angepaßt ist. Die Einheit zur Regelspannungserzeugung besteht aus einer Gleichrichterschaltung und einem Operationsverstärker, der an seinem nichtinvertierenden Eingang mit einem, einen nichtlinearen Widerstandsanteil aufweisenden RC-Glied beschaltet ist und so als ein aktiver Tiefpaß wirkt, durch den sich für die Regelspannungserzeugung eine von der Anstiegszeit der Regelspannung abweichende Abfallzeit ergibt. Durch das daraus resultierende Frequenzverhalten der abgeleiteten und der Lautstärkeregelstufe zugeführten Regelspannung werden auch die für den CB-Funk typischen Impulsstörungen schnell ausgeregelt.

## Beschreibung

Die Erfindung betrifft eine Schaltungsanordnung zur Unterdrückung des Rauschens im Empfangsteil eines CB-Funkgerätes oder eines CB-Empfängers.
Es ist bekannt, daß ein im CB-Funkverkehr empfangenes Signal in der Regel von Störungen und einem starken Rauschsignalanteil überlagert ist. Der CB-Funk ist naturgemäß eine Funkanwendung im Grenzbereich zwischen der Kurzwelle und den untersten VHF-Bändern im 27 MHz-Bereich. Physikalisch ist dieser Frequenzbereich gekennzeichnet durch extrem stark wechselnde Ausbreitungsbedingungen von Raum- und Bodenwellen mit sehr hohen Feldstärkeschwankungen sowie der Tatsache, daß elektrische Maschinen (Kollektormotoren, Zündanlagen in KFZ, Stromrichter, EDV usw.) gerade in diesem Grenzbereich besonders starke Störemissionen verursachen. Aus diesem Grunde wurde international dieser Frequenzbereich als für professionelle Kommunikationsverbindungen nicht geeignet angesehen. Daraus resultierte in den USA in den fünfziger Jahren die erste Freigabe für die Nutzung durch Privatpersonen in diesem Bereich. Aus dieser Zeit stammt auch das heute noch weltweit genutzte CB-Funk-Kanalraster von nur 10 kHz.
Bei Empfängern für den VHF- und UHF-Frequenzbereich ist es bekannt, zur Unterdrückung des Rauschens eine Schaltstufe vorzusehen, die bei Abwesenheit eines Nutzsignals das hochfrequentere Rauschen aus dem Zwischenfrequenzverstärker oder dem FM-Demodulator dekodiert und als Schaltkriterium verwendet. Zur Erzielung einer gleichmäßigen NF-Lautstärke und einer ausreichenden Unterdrückung von amplitudenmodulierten Störimpulsen aus der elektromagnetischen Umgebung werden dabei hochverstärkende Begrenzerschaltungen benutzt, die sich dadurch auszeichnen, daß bei fehlenden Empfangssignalen ein starkes Rauschen konstanter Lautstärke zu hören ist. Bei Anwesenheit von Nutzsignalen geht dieses Rauschen zurück (Rauschberuhigung bzw. Noise Quieting). Zur Gewinnung eines Schaltkriteriums verwendet man das über Hochpaßglieder oder aus der ZF vor dem Demodulator entnommene breitbandige NF-Grundrauschen. Die geringe Kanalbandbreite des CB-Funks läßt jedoch die Verwendung von Rauschsperrenschaltungen mit breitbandigen Rausch-Hochpaßfiltern nur eingeschränkt zu.
Auch aus der frühen CB-Funktechnik der USA bekannte Schaltungen, die aus der HF-Feldstärke im Nutzkanal über die übliche AM-Empfänger-Regelspannung ein Schaltkriterium ableiten, haben Probleme mit den fast immer vorhandenen Störfeldstärken und unkontrollierbaren Überreichweiten.
Während bei VHF-/UHF-Geräten meist eine einmalige Einstellung der Rauschsperre ausreicht, ist bei CB-Geraten, welche mit Schaltungen zur Rauschunterdrückung nach einem der beiden genannten Prinzipien arbeiten, das Herausführen eines Stellgliedes für die ständige Neueinstellung unbedingt erforderlich. Der Benutzer ist gezwungen, ständig den Rauschsperreneinsteller nachzujustieren, da sich die HF-Bedingungen bereits nach kurzer Betriebszeit wieder ändern können. Dies wird von den Anwendern als unangenehm empfunden. Aus UHF- bzw. VHF-Empfängern bekannte Schaltungen, bei welchen die Gewinnung von zur Rauschunterdrückung geeigneten Signalen im NF-Pfad erfolgt, sind aber, wegen der geschilderten besonderen Probleme, auf Empfänger für den CB-Funk nicht ohne weiteres übertragbar.
In der jüngeren Zeit sind spezielle Schaltungen für eine CB-Rauschunterdrückung bekannt geworden. So kommen in der Praxis CB-Funkgeräte zum Einsatz, bei denen der NF-Weg zum Lautsprecher bzw. Verstärker über ein Relais bzw. eine Schaltstufe "Ein" und "Aus" geschaltet wird. Nachteilig ist dabei, daß bei derartigen Geräten nur solche Signale als empfangswürdig durchgeschaltet werden, bei denen eine bestimmte Sprechlautstärke auf der sendenden Seite überschritten wird. Dadurch können Wortanfänge oder ganze Silben verlorengehen. Bei Störungen hat das Gerät nur die Möglichkeit, mit den vorgegebenen Verzögerungszeiten ganz aus- und wieder ganz einzuschalten. Eine andere bekannt gewordene Lösung leitet aus dem HF-Pegel im Nutzkanal eine Regelgröße ab, die bei geringer werdender HF-Feldstärke die NF-Lautstärke im Lautsprecher zurückstellt. Diese Lösung bringt die Nachteile der HF-pegelabhängigen Steuerung mit sich und erfordert Nachjustieren bei sich ändernden HF-Bedingungen.

Der Erfindung liegt daher die Aufgabe zugrunde, eine Schaltungsanordnung anzugeben, welche eine wirkungsvolle Rauschunterdrückung bei CB-Funkgeräten oder -empfängern ermöglicht, so daß die über den Lautsprecher dieser Geräte wiedergegebenen Nutzsignale als weitgehend störungsfrei empfunden werden.
Erfindungsgemäß wird die Aufgabe dadurch gelöst, daß bei einer Schaltungsanordnung zur Unterdrückung des Rauschens in CB-Funkgeräten bzw. -Empfängern im NF-Pfad in einem Rauschverstärker, dessen Eingang parallel zum Eingang der Laustärkeregelstufe liegt, und einer diesem Verstärker nachgeschalteten Einheit zur Regelspannungserzeugung eine der Lautstarkeregelstufe zugeführte Regelspannung abgeleitet wird, durch welche die Lautstärke gegenläufig zur Stärke des Rauschens geregelt wird. Bei einer Ausbildung der Anordnung ist der Rauschverstärker aus einer hinsichtlich ihres Ansprechens einstellbaren Verstärkerstufe und einem schmalbandigen Hochpaßfilter gebildet und die Einheit zur Regelspannungserzeugung besteht aus einer Gleichrichterschaltung und einem Operationsverstärker, der an seinem nichtinvertierenden Eingang mit einem, einen nichtlinearen Widerstandsanteil aufweisenden RC-Glied beschaltet ist. Dabei ist der Frequenzgang des schmalbandigen Hochpaßfilters an das typische Störspektrum des CB-Funks angepaßt, während der mit dem RC-Glied beschaltete Operationsverstärker als aktiver Tiefpaß wirkt. Durch den nichtlinearen Widerstandsanteil des RC-Gliedes ergibt sich für die Regelspannungserzeugung eine von der Anstiegszeit der Regelspannung abweichende Abfallzeit und somit ein Frequenzverhalten der abgeleiteten und der Lautstärkeregelstufe zugeführten Regelspannung, durch welches auch im CB-Funk typische Impulsstörungen schnell ausgeregelt werden.
Entsprechend einer vorteilhaften Ausbildung der erfindungsgemäßen Schaltungsanordnung ist das schmalbandige Hochpaßfilter als ein Tschebyscheff-Hochpaßfilter zweiter Ordnung ausgebildet. Dieses Filter weist in einem schmalen Frequenzbereich vorteilhafterweise bei etwa 4 kHz - ein gewolltes Überschwingen auf.
Als im Sinne der Erfindung vorteilhaft anzusehen ist es, wenn der Tiefpaß der Einheit zur Regelspannungserzeugung als Tschebyscheff-Tiefpaßfilter zweiter Ordnung ausgebildet ist.
Gemäß einer Ausgestaltungsform der Erfindung wird der nichtlineare Widerstandsanteil des in der Einheit zur Regelspannungserzeugung vorgesehenen RC-Gliedes dadurch realisiert, daß ohmsche Widerstände mit Schaltungselementen in Reihe liegen, die aus einer Diode und einem dazu parallel geschalteten ohmschen Widerstand bestehen. Auf diese Weise wird erreicht, daß die mit den Widerständen parallel geschalteten Dioden die Widerstände bei schnellen Anstiegsflanken des vom Rauschverstärker kommenden verstärkten Rauschsignals überbrücken und somit auch die Regelspannung schnell ansteigt, während die Abfallzeit der Regelspannung deutlich geringer ist, da die Dioden dann gesperrt sind und sich in dem RC-Glied andere Widerstandsverhältnisse einstellen.

Eine weitere vorteilhafte Ausführung betrifft die Einordnung zweier jeweils zwischen der Schaltungsmasse und der Betriebsspannung liegender und gleiche Teilerverhältnisse aufweisende Spannungsteiler in den Eingangsbereich der Lautstärkeregelstufe, wobei die Spannungsteiler zwischen ihren Teilerpunkten mit zwei gegensinnig in Reihe geschalteten Dioden verbunden sind und die Regelspannung über einen Widerstand an den Zusammenschaltpunkt dieser Dioden geführt ist. Dabei wird der Arbeitspunkt eines den Spannungsteilern nachgeschalteten Verstärkers in Abhängigkeit von der Höhe der an dem Zusammenschaltpunkt der Dioden anstehenden Spannung verändert. Erreicht dabei die an dem Zusammenschaltpunkt anstehende Spannung aufgrund der diesem Punkt zugeführten Regelspannung einen Wert, bei dem die Dioden sperren, so ist der Signalweg für das Nutzsignal gesperrt. Dies ist erfindungsgemäß bei einem stark rauschbehafteten Nutzsignal gegeben, bei dem die in der Schaltung abgeleitete Regelspannung dann den zum Sperren der Dioden führenden Wert annimmt.
Da es im internationalen Funkverkehr üblich ist, eine Signalbewertung nach dem RS-System vorzunehmen (R steht für Readability = Lesbarkeit, S steht für die Signalfeldstärke), wird bei einer weiteren vorteilhaften Ausführung der Schaltungsanordnung die erzeugte Regelspannung zusätzlich an den Eingang einer die Signalqualität des empfangenen Signals auswertenden und anzeigenden Schaltungseinheit geführt ist.
Der wichtigste Vorteil der Schaltungsanordnung besteht darin, daß ausschließlich die Signalqualität des bereits demodulierten NF-Signals beurteilt wird und die Regelung somit von der HF-Feldstärke und den CB-Funk-typischen Änderungen nicht abhängig ist. Dabei ist die NF-Filterschaltung besonders auf die im schmalbandigen CB-Funk auftretenden Störspektren ausgelegt, so daß sie aus Rauschen und Störsignalen eine Regelgröße erzeugt, die in der Lage ist, einen Regelverstärker derart zu steuern, daß die aus dem Lautsprecher wiedergegebenen Nutzsignale weitgehend als störungsfrei empfunden werden. Durch die besondere Auslegung der Regelzeitkonstanten (Anstieg und Abfall) entstehen weder Regelgeräusche noch der Gehöreindruck von Unterbrechungen des Nutzsignals. Eine weitere wesentliche Eigenschaft der Schaltung besteht darin, daß der Modulationsinhalt eines vorschriftsmäßigen Nutzsignals keinen Einfluß auf das Regelverhalten hat. In vorteilhafter Weise eignet sich die Schaltung sowohl zum unmittelbaren Einbau in vorhandene Geräte, als auch zur Nachrüstung in Form eines von außen anschließbaren Zusatzbausteins.

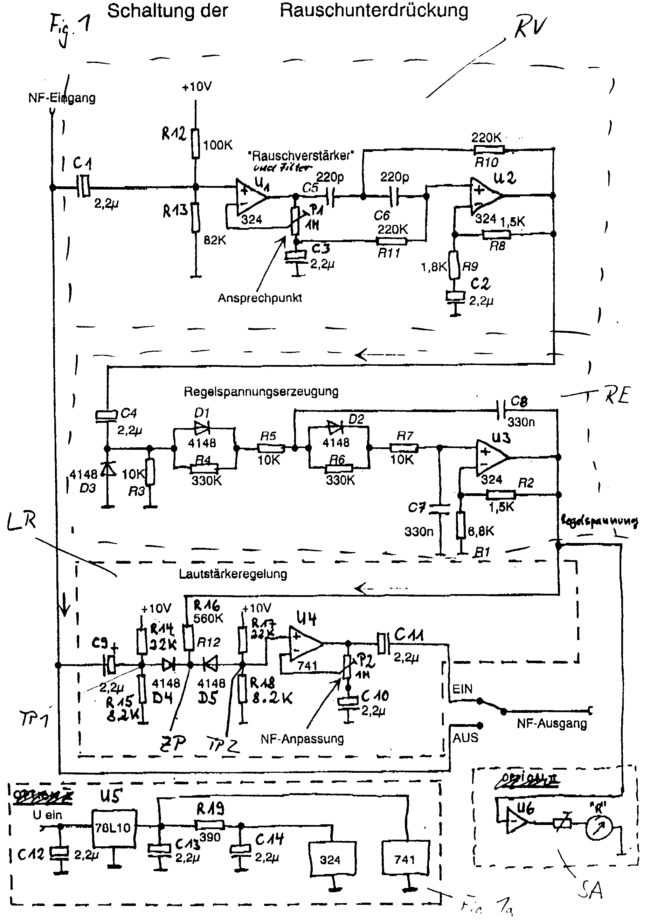

Die Erfindung soll an Hand eines Ausführungsbeispiels näher erläutert werden.
Die zugehörige Zeichnung zeigt den detaillierten Schaltplan einer möglichen Ausführung der erfindungsgemäßen Schaltungsanordnung.
Am NF-Eingang, über welchen das demodulierte und mit dem unerwünschten Rauschen überlagerte Nutzsignal einer Lautstärkeregelstufe LR zugeführt wird, liegt parallel zum Eingang der Lautstärkeregelstufe LR der Eingang einer Einheit RV zur Verstärkung des Rauschanteils. In dieser durch den Kondensator C 1 galvanisch entkoppelten Einheit RV wird das NF-Signal zunächst verstärkt. Die Verstärkerstufe ist vorliegend durch einen Operationsverstärker U 1 gebildet. Durch die Dimensionierung der Widerstände R 12 und R 13 liegt der Arbeitspunkt des Operationsverstärkers U 1 zur besseren Aussteuerbarkeit etwas unterhalb der halben Betriebsspannung U_{B}/2. Über das Potentiometer P 1 läßt sich die Verstärkung in weiten Grenzen einstellen und ein Ansprechpunkt des Verstärkers bestimmen. Der Verstärkerstufe folgt ein schmalbandiges Hochpaßfilter. In dem dargestellten Beispiel ist dieses Filter durch die Kombination von C 5, C 6, R 11, R 10, R 8, R 9 und U 2 als ein Tschebyscheff-Hochpassfilter zweiter Ordnung ausgebildet. Der Frequenzgang des Filters wird durch einen beabsichtigten Überschwinger bei einer Frequenz von etwa 4 kHz festgelegt und ist besonders an das typische Störspektrum des CB-Funks angepaßt.
Am Kondensator C 3 liegt eine Gleichspannung an, die dem Gleichspannungsanteil der verstärkten NF entspricht. Das Tschebyscheff-Filter nutzt diese Gleichspannung an C 3 als Arbeitspunkt. Die vorliegende Schaltung arbeitet mit Operationsverstärkern, die üblicherweise mit einer positiven und einer negativen Versorgungsspannung betrieben werden. Durch das Einfügen von C 3 und C 2 wird jedoch eine "schwimmende Masse" gebildet, die es ermöglicht, die Operationsverstärker ohne negative Versorgungsspannung zu betreiben. Das in einem relativ schmalen Frequenzbereich verstärkte, am Ausgang des Operationsverstärkers U 2 liegende Rauschsignal wird der Einheit RE zur Erzeugung der Regelspannung zugeführt. Die NF wird über einen Koppelkondensator C 4 eingekoppelt, wobei D 3 dafür sorgt, daß nur positive Spannungen weiterverarbeitet werden. Durch die weiteren in dieser Einheit RE folgenden Schaltungsteile ist ein Tschebyscheff-Tiefpaßfilter zweiter Ordnung gebildet. Der nichtinvertierende Eingang des Operationsverstärkers U 3 ist dabei mit einem RC-Glied D 1, R 4, R 5, D 2, R 6, R 7, C 7 beschaltet, welches einen aus der Parallelschaltung der Widerstände R 4 und R 6 mit den Dioden D 1 und D 2 resultierenden nichtlinearen Widerstandsanteil aufweist. Diese spezielle Ausgestaltung der Schaltung bewirkt, daß sich für die Regelspannung eine von der Anstiegszeit verschiedene Abfallzeit einstellt. Während der Startzeit der Regelspannung (positiver Spannungssprung) schalten die Dioden D 1 und D 2 durch und überbrücken damit im wesentlichen die Widerstände R 4 und R 6, wodurch ein Tiefpaßfilter mit einer Dimensionierung von 2 x 10 kOhm und 2 x 330 nF gebildet ist. Während der Abfallzeit der Regelspannung sind D 1 und D 2 nicht mehr leitend. Es ergibt sich somit ein Tiefpaßfilter mit zwei Widerständen zu je 340 kOhm, den Kondensatoren 330 nF und den, Operationsverstärker U 3. Durch die daraus resultierende unterschiedliche Anstiegs- und Abfallzeit ist die Schaltung nicht nur in der Lage, gewöhnliches Rauschen zu unterdrücken, sondern auch für den CB-Funk typische Impulsstörungen schnell auszuregeln.
Bei der in dem dargestellten Beispiel verwendeten Lautstärkeregelung LR sind im Eingangsbereich zwei jeweils zwischen der Schaltungsmasse und der Betriebsspannung liegende und gleiche Teilerverhältnisse aufweisende Spannungsteiler R 14, R 15 und R 17, R 18 vorgesehen, die zwischen ihren Teilerpunkten TP 1, TP 2 mit zwei gegensinnig in Reihe geschalteten Dioden D 4, D 5 verbunden sind. Dieser Schaltungsteil arbeitet als über die Widerstände R 14, R 15, R 16, R 17 und R 18 vorgespannter Diodenregler, wobei über den an den Kathoden der beiden Dioden D 4 und D 5 liegenden Widerstand R 16 die Regelspannung zugeführt wird. Der Arbeitspunkt des den Spannungsteilern R 14, R 15 und R 17, R 18 nachgeschalteten Verstärkers U 4 wird somit in Abhängigkeit von der Höhe der am Zusammenschaltpunkt ZP der Dioden D 4, D 5 anstehenden, um den Spannungsabfall an dem Widerstand R 16 verringerten Regelspannung verändert. Solange die Spannung am Zusammenschaltpunkt ZP gering ist, sind die Dioden D 4, D 5 durchgeschaltet und lassen die NF durch. Mit steigender Gleichspannung an R 16 beginnen die Dioden D 4, D 5 allmählich zu sperren bis sie bei weiter steigender Spannung das NF-Signal vollständig unterdrücken.
Die Schaltung eignet sich gleichermaßen zum nachträglichen Einbau in vorhandene CB-Funkgeräte, als auch zum externen Anschluß für besonders dazu vorbereitete CB-Funkgeräte über eine Zubehöranschlußbuchse. Dazu muß die Lautstärkeregelstufe LR an verschiedene Arten von NF-Verstärkern in den CB-Geräten anpaßbar sein. Der mit P 2 einstellbare Operationsverstärker U 4 stellt die rückwirkungsfreie Trennung des NF-Verstärkers und die Anpassung an die geforderte Eingangsspannung des Funkgeräte-NF-Verstärkers her. Bei Funkgeräten, die besonders für die Verwendung einer steckbaren Zusatzplatine vorbereitet werden, kann die Lautstärkeregelstufe LR auch alternativ über einen Ballasttransistor im Funkgerät vorgenommen werden, der die in dem Beispiel dargestellte Einheit LR ersetzt.
In dem angegebenen Ausführungsbeispiel wird die an dem Ausgang der Regelspannungserzeugung RE anstehende Regelspannung zusätzlich einer Schaltungseinheit SA zugeführt. Diese Einheit dient dazu, wie im Funkverkehr vielfach üblich, die Signalqualität des empfangenen Signals in einer Anzeige sichtbar zu machen. Die Spannungsversorgung der erfindungsgemäßen Schaltung erfolgt beispielsweise entsprechend dem in der Fig. 1a angegebenen Blockschaltbild, wobei die Spannungsstabilisierung U 5 bei Geräten, welche intern bereits eine stabilisierte Betriebsspannung bereitstellen, entfallen kann.

## Patentansprüche

1. Schaltungsanordnung zur Unterdrückung des Rauschens im Empfangsteil eines CB-Funkgerätes oder eines CB-Empfängers mit einem HF-Eingangsteil, einem Demodulator und einer sich an den Demodulator anschließenden Lautstärkeregelstufe, welcher das demodulierte und mit dem Rauschen überlagerte Nutzsignal zugeführt wird, **dadurch gekennzeichnet**, **daß** zum Eingang der Lautstärkeregelstufe (LR) der Eingang einer Einheit (RV) zur Verstärkung des Rauschens parallel geschaltet und der Ausgang der Einheit (RV) mit einer Einheit (RE) zur Erzeugung einer der Lautstärkeregelstufe (LR) zugeführten Regelspannung verbunden ist, so daß die Lautstarke des empfangenen Nutzsignals durch die in der Einheit (RE) abgeleitete Regelspannung gegenläufig zur Stärke des Rauschens geregelt wird.

2. Schaltungsanordnung nach Anspruch 1, **dadurch gekennzeichnet, daß** die Einheit (RV) zur Rauschverstärkung aus einer hinsichtlich ihres Ansprechens einstellbaren Verstärkerstufe (U 1) und einem schmalbandigen, an das typische Störspektrum des CB-Funks angepaßten Hochpaßfilter (C 5, C 6, R 10, R 11, R 8, R 9, U 2) gebildet ist und daß die Einheit (RE) zur Regelspannungserzeugung aus einer Gleichrichterschaltung (D 3) und einem Operationsverstärker (U 3) besteht, der an seinem nichtinvertierenden Eingang mit einem, einen nichtlinearen Widerstandsanteil aufweisenden RC-Glied (D 1, R 4, R 5, D 2, R 6, R 7, C 7) beschaltet ist, so daß das RC-Glied (D 1, R 4, R 5, D 2, R 6, R 7, C 7), der Operationsverstärker (U 3) und weitere Schaltelemente (C 8, R 1, R 2) einen aktiven Tiefpaß ausbilden, der durch sein Frequenzverhalten an dem mit der Lautstärkeregelstufe (LR) verbundenen Ausgang eine Regelspannung bereitstellt, die auch im CB-Funk typische Impulsstörungen schnell ausregelt.

3. Schaltungsanordnung nach Anspruch 1 oder 2, **dadurch gekennzeichnet, daß** das schmalbandige Hochpaßfilter (C 5, C 6, R 10, R 11, R 8, R 9, U 2) als ein Tschebyscheff-Hochpaßfilter zweiter Ordnung ausgebildet ist.

4. Schaltungsanordnung nach einem der Ansprüche 1 bis 3, **dadurch gekennzeichnet, daß** der Tiefpaß (D 1, R 4, R 5, D 2, R 6, R 7, C 7, U 3, C 8, R 1, R 2) der Einheit (RE) zur Regelspannungserzeugung als Tschebyscheff-Tiefpaßfilter zweiter Ordnung ausgebildet ist.

5. Schaltungsanordnung nach einem der vorhergehenden Ansprüche, **dadurch gekennzeichnet, daß** der nichtlineare Widerstandsanteil des in der Einheit (RE) zur Regelspannungserzeugung vorgesehenen RC-Gliedes (D 1, R 4, R 5, D 2, R 6, R 7, C 7) aus der Reihenschaltung ohmscher Widerstände (R 5, R 7) mit Schaltungselementen, die jeweils aus einer Diode (D 1, D 2) und einem dazu parallel geschalteten ohmschen Widerstand (R 4, R 6) bestehen, gebildet ist.

6. Schaltungsanordnung nach einem der vorhergehenden Ansprüche, **dadurch gekennzeichnet, daß** im Eingangsbereich der Lautstärkeregelstufe (LR) zwei jeweils zwischen der Schaltungsmasse und der Betriebsspannung liegende und gleiche Teilerverhältnisse aufweisende Spannungsteiler (R 14, R 15; R 17, R 18) eingeordnet und zwischen ihren Teilerpunkten (TP 1, TP 2) mit zwei gegensinnig in Reihe geschalteten Dioden (D 4, D 5) verbunden sind, wobei die am Ausgang der Einheit (RE) anstehende Regelspannung über einen Widerstand (R 16) an den Zusammenschaltpunkt (ZP) der beiden Dioden (D 4, D 5) geführt ist, so daß sich der Arbeitspunkt eines den Spannungsteilern (R 14, R 15; R 17, R 18) nachgeschalteten Vertärkers (U 4) in Abhängigkeit von der Höhe der am Zusammenschaltpunkt (ZP) anstehenden, um den Spannungsabfall an dem Widerstand (R 16) verringerten Regelspannung verändert und der Signalweg für das Nutzsignal gesperrt ist, wenn die an dem Zusammenschaltpunkt (ZP) anstehende Spannung ein Sperren der Dioden (D 4, D 5) bewirkt.

7. Schaltungsanordnung nach einem der vorhergehenden Ansprüche, **dadurch gekennzeichnet, daß** die erzeugte Regelspannung zusätzlich an den Eingang einer die Signalqualität des empfangenen Signals anzeigenden Schaltungseinheit (SA) geführt ist.
